# EUROPEAN PATENT SPECIFICATION

(11) **EP 0 304 336 B1**
(45) Date of publication and mention of the grant of the patent: **09.11.1994**
(21) Application number: 88307733.1
(22) Date of filing: 19.08.1988
(51) Int. Cl.: H01L 31/10, H01L 31/18, H01L 27/14

(54) **Photoelectric conversion device and method for producing the same**
Photoelektrische Umwandlungsanordnung und Herstellungsverfahren
Dispositif de conversion photoélectrique et son procédé de fabrication

(30) Priority: 21.08.1987 JP 208609/87
(43) Date of publication of application: 22.02.1989
(73) Proprietor: CANON KABUSHIKI KAISHA, Tokyo (JP)
(72) Inventor: Tashiro, Kazuaki, Hadano-shi Kanagawa-ken (JP); Yamanobe, Masato, Machida-shi Tokyo (JP); Komatsu, Toshiyuki, Hiratsuka-shi Kanagawa-ken (JP)
(74) Representative: Beresford, Keith Denis Lewis

(56) References cited:
- US-A- 4 461 956
- US-A- 4 607 168
- JAPANESE JOURNAL OF APPLIED PHYSICS, supplements, 1983 suppl., EXTENDED ABSTRACTS OF THE 15th CONFERENCE ON SOLID STATE DEVICES AND MATERIALS, pages 201-204, Tokyo, JP; F. OKUMURA et al.: "Amorphous Si:H linear image sensor operated by a-Si:H TFT array"
- INTERNATIONAL ELECTRON DEVICES MEETING, Washington, DC, 1st-4th December 1985, IEDM TECHNICAL DIGEST, pages 436-439, IEEE, New York, US; H. ITO et al.: "a-SI:H TFT array driven linear image sensor with capacitance coupling isolation structure"

## Description

The present invention relates to a photoelectric conversion device having a photodiode, a switching element and a wiring matrix on a common insulating substrate. The present invention also relates to a method of producing a photoelectric conversion device of the aforesaid type.

An image reading system utilising a reduction optical system and a CCD type scanner has been employed in various equipment, such as facsimile machines, image readers and digital scanners but recent developments in thin film semiconductive materials, represented by hydrogenated amorphous silicon (hereinafter referred to as A-Si:H) have stimulated the development of so-called long contact photoelectric conversion devices, in which photoelectric conversion elements and switching elements are formed on a long substrate for reading an original image with an optical system of the same size.

The aforesaid semiconductive material, A-Si:H, may be used not only as a semiconductor material for photoelectric conversion but also as a thin film field effect transistor, hereinafter referred to as a TFT. It has therefore been proposed to form a semiconductor layer of said photoelectric conversion elements and that of said TFT's with A-Si:H, on a common substrate, together with a wiring matrix.

Furthermore, in order to increase reading speed and to achieve image reading with satisfactory tonal rendition, image reading devices utilizing pin photodiodes have been developed, made of A-Si:H as the photoelectric conversion elements, formed together with TFT's and a wiring matrix on a substrate.

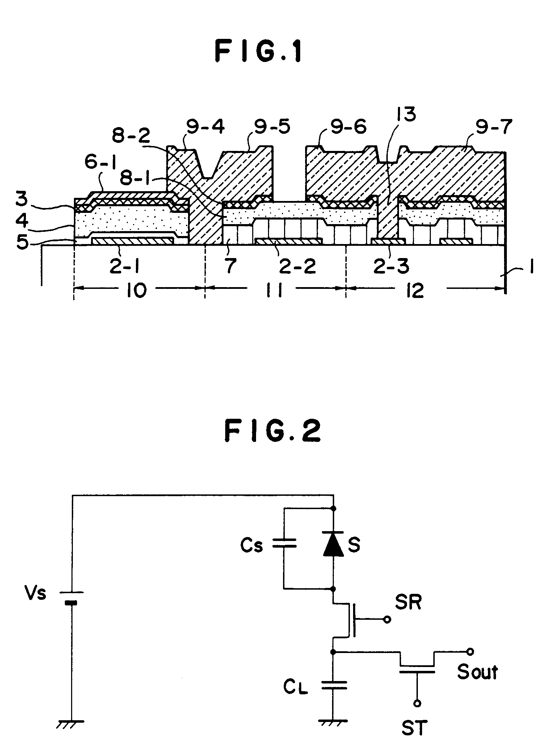

Fig. 1 is a partial cross-sectional view of a conventional photoelectric conversion device explained above, showing a photoelectric conversion device 10 composed of a pin photodiode utilizing A-Si:H, a switching element 11 of an inverse stagger type thin film transistor using an A-Si:H semiconductor layer and a wiring matrix 12.

The photodiode is composed of a lower metal electrode 2-1; an n-type A-Si:H layer 5; an intrinsic A-Si:H layer 4; a p-type A-Si:H layer 3; an indium tin oxide (ITO) layer 6-1 constituting an upper electrode; and a metal layer 9-4. The TFT is composed of a metal gate electrode 2-2; an insulating layer 7; an intrinsic A-Si:H layer 8-1; an n-type A-Si:H layer 8-2; a source electrode 9-6; and a drain electrode 9-5. The wiring matrix has the same structure as the TFT, in order to simplify the manufacturing process.

Photodiode S is reverse biased, in the normal state, by a voltage Vs to charge a parasitic capacitance Cs. When the photodiode is irradiated with light, said capacitance is discharged. Thereafter, switch SR is closed, whereby a charging current flows to compensate the dissipated charge, thereby again charging the parasitic capacitance Cs. Simultaneously, a load capacitor CL is charged by an amount corresponding to said discharge current. Then, said switch SR is turned off and another switch ST is turned on, whereby the charge accumulated in said capacitor CL is read and released from a terminal Sₒᵤₜ.

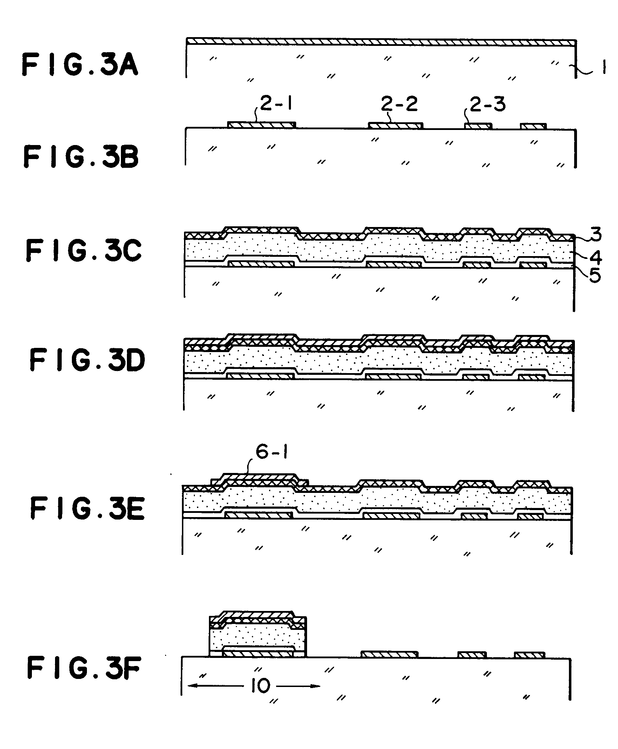

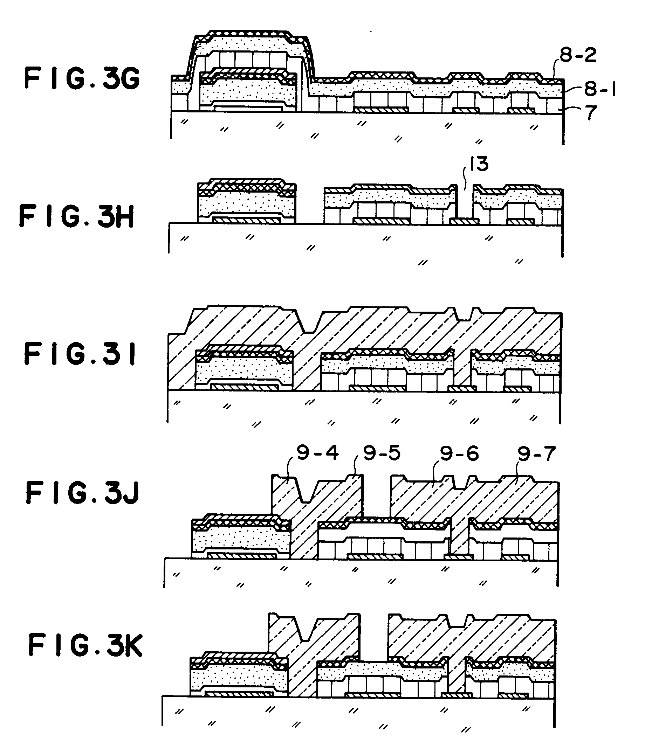

The following is an explanation of the manufacturing method of such a photoelectric conversion device, referring to Figures 3A to 3K:
(a) At first, a first metal, chromium, is deposited by vacuum evaporation to a thickness of 100 nanometres (1000 Angstrom) on a cleaned glass substrate 1.
(b) Then, a photoresist pattern of a desired shape is formed by a photolithographic process, which is used as a mask for wet etching said chromium layer, thereby forming lower electrodes 2-1, 2-2 and 2-3.
(c) Next, the n-type A-Si:H layer 5, having a thickness of 100 nano metre (1000 Angstrom) is deposited by plasma CVD from PH₃ gas and SiH₄ gas. Subsequently, the intrinsic semiconductor layer 4 having a thickness of 500 nanometres (5000 Angstrom) is deposited from SiH₄ gas, and then boron-doped p-type A-Si:H layer 3 having a thickness of 10 nano metre (100 Angstrom) is deposited from B₂H₆ gas and SiH₄ gas.
(d) A transparent ITO electrode layer, having a thickness of 100 nanometres (1000 Angstrom) is formed by sputtering.
(e) A photoresist pattern of a desired shape is formed by a photolithographic process and is used as a mask for eliminating the unnecessary portions of the ITO layer by wet etching, thereby forming the upper electrode 6-1 of the photodiode.
(f) The photoresist pattern formed in step (e) is used as a mask for eliminating the unnecessary portions of the n-, i- and p-layers by dry etching, thereby forming the photodiode 10.
(g) Then, the insulating layer 7, composed of amorphous silicon nitride having a thickness of 300 nanometres (3000 Angstrom) is deposited by plasma CVD from NH₃ gas and SiH₄ gas. Subsequently, the intrinsic A-Si:H layer 8-1 is deposited from SiH₄ gas, and the n-type A-Si:H layer 8-2 having a thickness of 50 nanometres (500 Angstrom) is deposited from PH₃ gas and SiH₄ gas.
(h) A photoresist pattern of a desired shape is formed by a photolithographic process and is used as a mask for dry etching the silicon nitride layer, i- and n-layers, thereby patterning the TFT and the wiring matrix and the contact hole 13. (i) A second metal layer having a thickness of 1500 nanometres (15000 Angstrom) composed of aluminum, is deposited by vacuum evaporation.
(j) A photoresist pattern of a desired shape is formed by a photolithographic process and is used as a mask for eliminating the unnecessary portions of aluminum by wet etching, thereby forming the upper electrode 9-4 of the photodiode, the source and drain electrodes 9-6, 9-5 of the TFT, and the upper electrode 9-4 of the wiring matrix.
(k) The photoresist pattern formed in the step (j) is used as a mask for eliminating the unnecessary portions of the n-type A-Si:H layer, such as the channel portion of the TFT, by dry etching.
(l) Finally, a protective layer is formed, for example with an organic resin.

The photoelectric conversion device is obtained through the above-explained steps.

However, in the conventional example explained above, the semiconductor layer of the photodiode and that of the TFT are prepared in separate steps and are photolithographically patterned at different stages, so that the efficiency of utilization of the formed A-Si:H films is very poor. Also, the procedure has many process steps and is complex, leading to a reduced yield and an increased cost, thereby effectively eliminating the advantage of making an integral structure on the same substrate.

A known photoelectric converter in a solid state assembly is shown in United States Patent No. 4461956. A converter comprises sections formed on the same substrate, including a photoelectric converting section constituted of a number of photoelectric converting elements arranged in an array, each element having a light receiving surface for the input of light information. In addition, a signal processing circuit section comprises a number of accumulating means, each providing for each of said photoelectric converting elements, for the accumulation of signals produced as outputs from the corresponding photoelectric converting elements. A number of transfer means for transferring the signals accumulated in the corresponding accumulating means to other places are also provided, along with an array of a number of transistors wired in a two dimensional matrix, to drive a number of the transfer means in time series, said photoelectric converting elements and the transfer means and the transistors constituting the signal processing circuit section and being constituted of thin semiconductor films.

It is an object of the present invention to provide an improved photoelectric conversion device.

This object is achieved by the features of claim 1.

The photoelectric conversion device may be used in a facsimile machine, an image reader or a digital scanner as claimed in claim 3.

According to a second aspect of the present invention, there is provided a process for producing a thin film photoelectric conversion device as featured in claim 4.

The invention will now be described by way of example only, with reference to the accompanying drawings, in which:
Fig. 1 is a partial cross-sectional view of a conventional photoelectric conversion device;
Fig. 2 is a single-bit equivalent circuit of said conventional photoelectric conversion device;
Figs. 3A to 3K are views showing the manufacturing method of said conventional photoelectric conversion device;
Fig. 4 is a partial cross-sectional view of a photoelectric conversion device of the present invention;
Fig. 5 is a single-bit equivalent circuit showing the function of the photoelectric conversion device shown in Fig. 4;
Fig. 6A is a plan view of two pixels of a long contact-type photoelectric conversion device composed of a linear array of a plurality of the photoelectric conversion element of the cross-sectional structure shown in Fig. 4;
Fig. 6B is a cross-sectional view of the photoelectric conversion device along a line B-B shown in Fig. 6A;
Fig. 6C is a cross-sectional view of the photoelectric conversion device along a line C-C shown in Fig. 6A;
Fig. 7 is an equivalent circuit of the photoelectric conversion device shown in Figs. 6A, 6B and 6C;
Fig. 8 is a timing chart showing gate voltage pulses; and
Figs. 9A to 9J are views showing the manufacturing method of the photoelectric conversion device of the present invention.

### DESCRIPTION OF THE PREFERRED EMBODIMENTS

Now the present invention will be clarified in detail by preferred embodiments thereof shown in the attached drawings.

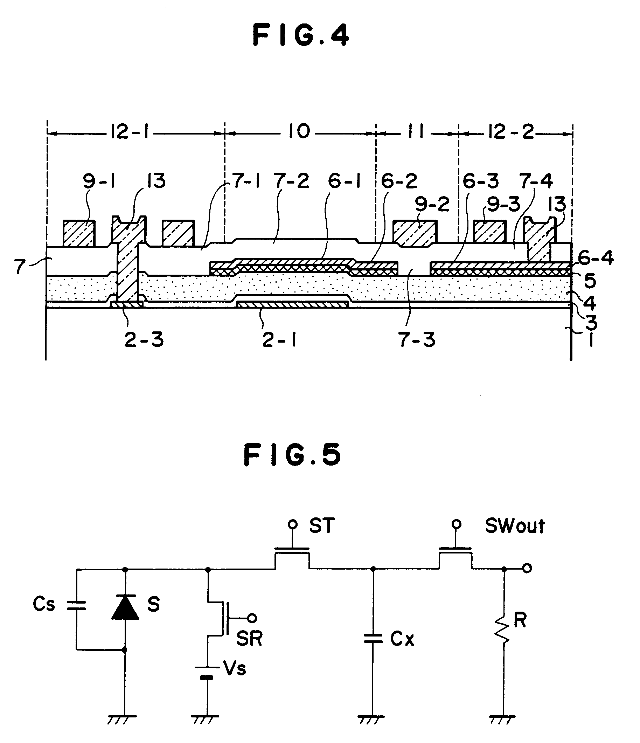

Fig. 4 is a schematic cross-sectional view of a photoelectric conversion device embodying the present invention, best representing the features of the present invention.

In Fig. 4 there are shown a pin photodiode 10; a TFT 11, and wiring matrixes 12-1, 12-2. On a substrate 1, there are formed a lower electrode 2-1 of the photodiode and a lower electrode 2-3 of the wiring matrix by a first metal layer. On said substrate and lower electrodes, there are formed a p-type A-Si:H layer 3; an intrinsic A-Si:H layer 4; and an n-type A-Si:H layer 5 in this order. Then, on the photodiode, TFT and wiring matrix there are formed, by an ITO film, an upper electrode 6-1, a source electrode 6-2, a drain electrode 6-3 and an individual electrode 6-4. On said ITO film and semiconductor layer there is formed an amorphous silicon nitride layer 7 serving as a passivation layer 7-2 in the photodiode, interlayer insulating layer 7-1, 7-4 in the wiring matrixes, and a gate insulating film 7-3 in the TFT. In said insulating layer there is formed a second metal layer to obtain upper electrode 9-1, 9-3 of the wiring matrixes and a gate electrode of the TFT.

The present invention is featured by a fact that the p-, i- and n-layers have a common layer structure at least in the photodiode, TFT and wiring matrixes which can therefore be produced through a common process.

In the wiring matrixes, two-layered wirings can be formed either by first and second metal layers or by the first or second metal layer and a transparent ITO layer, and a suitable combination can be selected in consideration of the resistance of wiring and the ease in process. In the former case the semiconductor layer is partially left between the upper and lower wirings, but the presence of the semiconductor layers 3, 4 is not a problem as long as the upper and lower wirings are mutually insulated.

The TFT is designed as n-channel type, in consideration of the characteristics of amorphous silicon. Under the semiconductor layer 4, there is formed the p-type A-Si:H layer, which is substantially grounded by connection with the lower electrode of the photodiode. Consequently the source and drain electrodes and the p-layer are inversely biased, whereby the leak between the upper and lower electrodes is practically negligible. Also the lateral through said p-layer is negligible since the thickness thereof can be reduced to the order of 100 Å. Thus the presence of said p-layer is practically negligible for the function of the TFT.

Fig. 5 is a single-bit equivalent circuit showing the function of the photoelectric conversion device shown in Fig. 4. A photodiode S is inversely biased by a voltage Vs through a switch SR, so that a parasite capacitance Cs is charged. When the switch SR is turned off, the charge in said parasite capacitance Cs is discharged in response to irradiating light. After a predetermined discharge time, a switch ST is turned on to transfer the remaining charge in the parasite capacitance Cs to a reading capacitor Cx. Subsequently said switch ST is turned off and a switch SWout is turned on to release a voltage across a resistor R. Said switch SWout and resistor R are formed in an external IC, but other circuit components are formed on a same substrate.

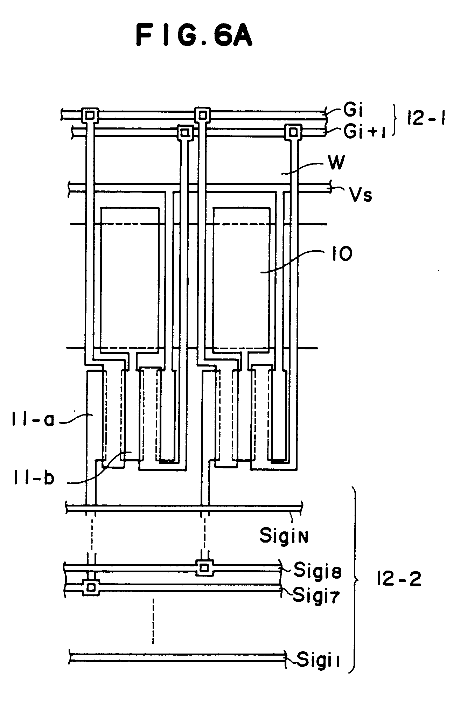

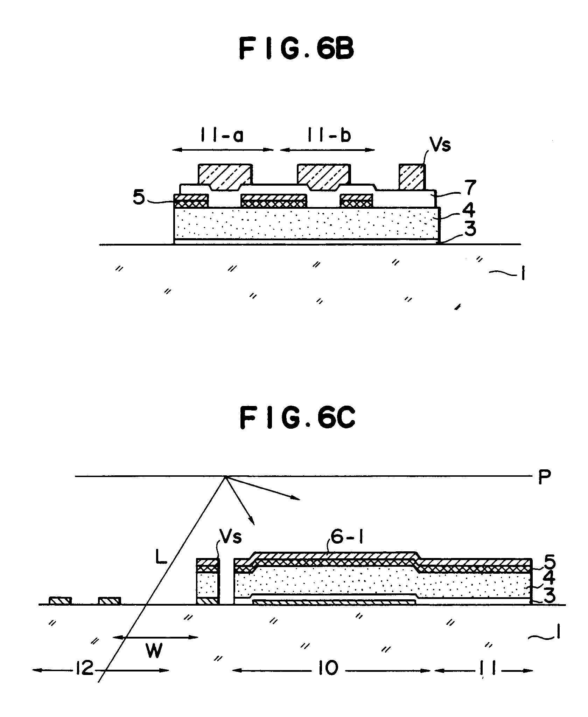

Fig. 6 shows a linear contact-type photoelectric conversion device of lensless type, composed of a plurality of the single-bit circuits shown in Fig. 5 and having the cross-sectional structure shown in Fig. 4, with a matrix switch array.

Fig. 6A is a plan view of two pixels, while Fig. 6B is a cross-sectional view along a line B-B in Fig. 6A, and Fig. 6C is a cross-sectional view along a line C-C in Fig. 6A.

In these drawings there are shown photodiode 10; transfer TFT's 11-a; charging TFT's 11-b; a TFT gate wiring matrix 12-1; a signal wiring matrix 12-2; and a light intake window W. For the purpose of simplicity, the semiconductor layer and the insulating layer are not shown.

In the lensless type device, as shown in Fig. 6C, the light enters the substrate from a face thereof opposite to the photosensors and illuminates an original P through said light intake window W of the substrate, and the light scattered by said original P is received by the photosensors without any particular optical system.

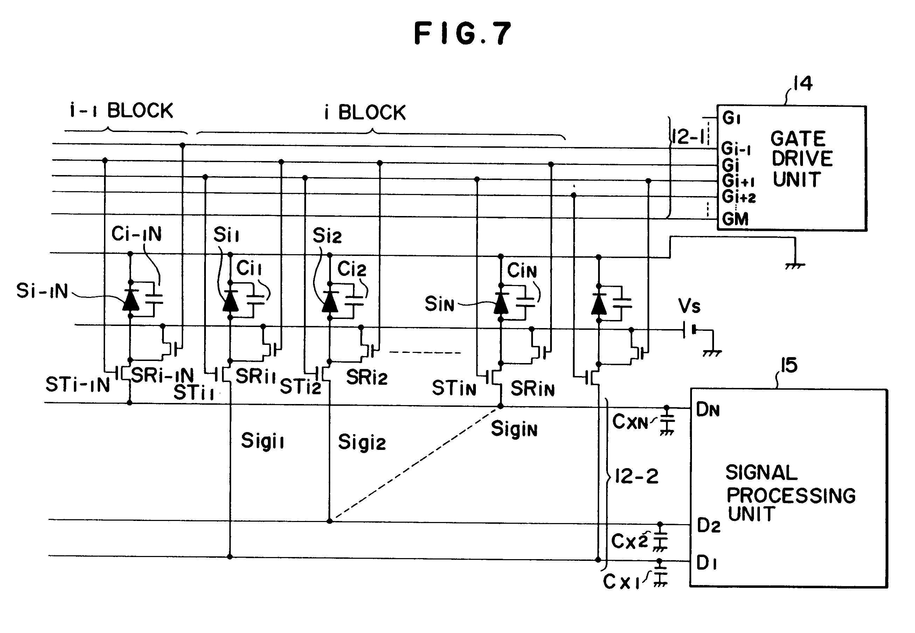

Fig. 7 is an equivalent circuit of the photoelectric conversion device explained above.

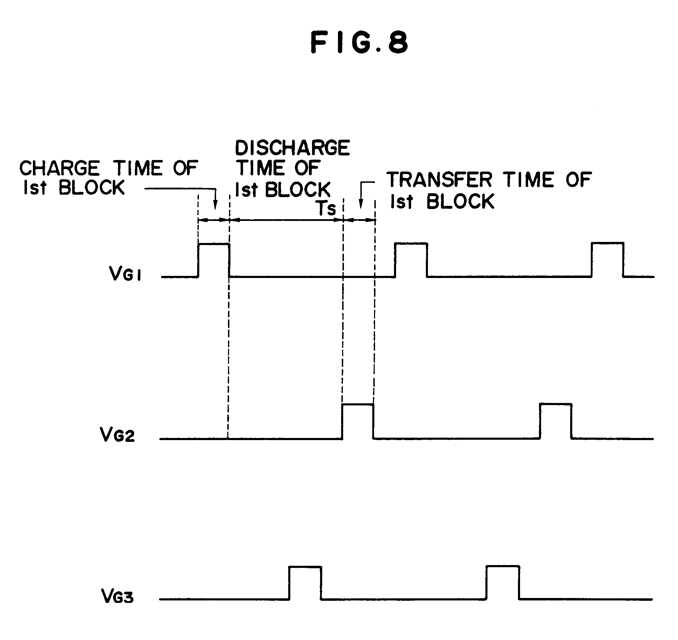

Fig. 8 is a timing chart of gate voltage pulses.

In Fig. 7, photodiodes Sᵢ₁, Sᵢ₂, ... , S_{iN} (hereinafter written as Sᵢ) constitute photoelectric conversion elements 10 in a block i. There are also shown parasite capacitances Cᵢ₁, Cᵢ₂, ... , C_{iN} (hereinafter written as Cᵢ) of the photodiodes; transfer switches STᵢ₁, STᵢ₂, ... , ST_{iN} (hereinafter written as STᵢ) for transferring the charges of the parasite capacitances Cᵢ to load capacitors Cₓ₁, Cₓ₂, ..., Cₓₙ, and charging switches SRᵢ₁, SRᵢ₂, ... , SR_{iN} for charging the parasite capacitances Cᵢ in advance. In the present embodiment the TFT switches 11 are composed of transfer switches STᵢ and charging switches SRᵢ. Individual electrodes Sigᵢ₁, Sigᵢ₂, ... , Sig_{iN} constitute the signal line matrix in the block i.

These photodiodes Si, parasite capacitances Cᵢ, transfer switches STᵢ and charging switches SRᵢ are arranged in a linear array and is divided into N x M blocks.

The gate electrodes of the transfer switches STᵢ and those of the charging switches SRᵢ, arranged in an array, are connected to matrix wirings 12-1. The gate electrodes of the charging switches SRᵢ in a same block are commonly connected to a line Gᵢ, and the gate electrodes of the transfer switches STᵢ are commonly connected to the common line Gᵢ₊₁ for the gate electrodes of the charging switches SRᵢ₊₁ of the next group.

As shown in Fig. 8, a gate driving unit 14 supplies gate driving lines G₁, ... , G_{M} in succession with selecting pulses V_{G1}, ... , V_{GM}. When the gate driving line G₁ is selected, the charging switches SR₁₁, SR₁₂, ... , SR_{1N} are turned on whereby the photodiodes S₁₁, S₁₂, ... , S_{1N} are inversely biased by a biasing voltage source Vₛ and the parasite capacitances C₁₁, C₁₂, .... , C_{1N} are charged.

Then, when the charging switches SR₁₁, SR₁₂, ... , SR_{1N} are turned off through the gate driving line G₁, the charges in the parasite capacitances C₁₁, C₁₂, ... , C_{1N} are dissipated by light in a predetermined period Tₛ whereby charges remain in amounts corresponding to the amounts of light. After said period Tₛ, the gate driving line G₂ is selected to turn on the transfer switches ST₁₁, ST₁₂, ... , ST_{1N} whereby the charges remaining in the parasite capacitances C₁₁, C₁₂, ... , C_{1N} are transferred through the individual electrodes Sig₁₁, Sig₁₂, ... , Sig_{1N} to the load capacitors Cₓ₁, Cₓ₂, ... , C_{xN}. Said charges are supplied in succession to a signal processing unit 15 and converted into serial signals. The above-explained operation is repeated for different blocks, thereby reading the information on a line.

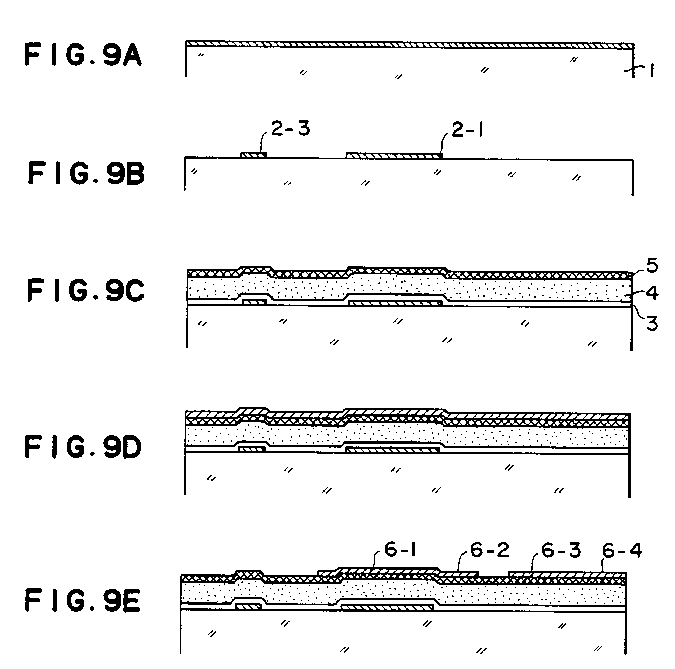

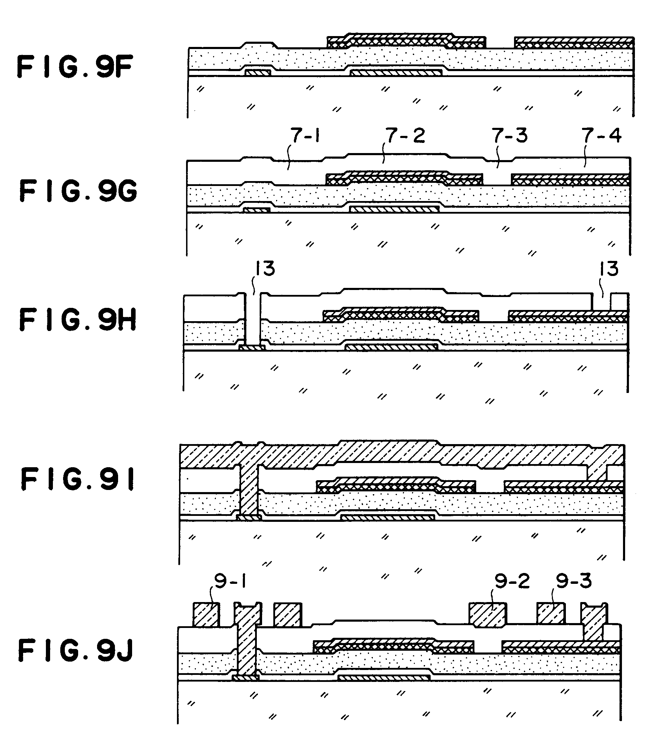

In the following there will be explained the process for producing the above-explained photoelectric conversion device, while making reference to Figs. 9A to 9J showing different process steps in schematic partial cross-sectional views:
(a) On a cleaned glass substrate 1 of sufficient flatness, aluminum is deposited in a thickness of 1000 Å by vacuum deposition (10Å=1nm).
(b) A photoresist pattern is formed in a desired shape by a photolithographic process and is used as a mask for eliminating unnecessary portions of the aluminum layer by wet etching with aqueous solution HNO₃/H₃PO₄/CH₃COOH, thereby forming the lower electrode 201 of the wiring matrix and the lower electrode 2-2 of the photodiode.
(c) Then a p-type A-Si:H layer 3 of a thickness of 100 Å highly doped with boron is deposited by plasma CVD from SiH₄ gas and B₂H₆ gas. Then an intrinsic A-Si:H layer 4 of a thickness of 5000 Å is deposited from SiH₄ gas. Then an A-Si:H layer 5 of a thickness of 1000 Å highly doped with phosphor is deposited from SiH₄ gas and PH₃ gas.
(d) An indium tin oxide (ITO) layer of a thickness of 1000 Å for forming transparent electrodes is deposited by vacuum evaporation.
(e) A photoresist pattern of a desired shape is formed by a photolithographic process, and is used as a mask for eliminating the unnecessary portions of the ITO layer by wet etching with aqueous solution of FeCl₃/HCl thereby forming the upper electrode 6-1 of the photodiode, the source electrode 6-2 and drain electrode 6-4 of the TFT.
(f) The photoresist pattern used for patterning the ITO layer is used as a mask for eliminating the unnecessary portions of the n-layer, thereby forming the channel portion of the TFT.
(g) An insulating layer composed of amorphous silicon nitride is deposited by plasma CVD from SiH₄ gas and NH₃ gas. Said insulating layer is utilized as the insulating interlayer 7-1 of the wiring matrixes, the passivation film 7-2 in the photodiode and the gate insulating film 7-3 in the TFT.
(h) A photoresist pattern of a desired shape is formed by a photolithographic process and is used as a mask for dry etching the silicon nitride layer and three p-i-n layers with CF₄ gas, thereby forming contact holes 13 of the wiring matrixes and separating the individual elements.
(i) As the second metal layer, aluminum is deposited in a thickness of 10000 Å by vacuum evaporation.
(j) A photoresist pattern of a desired shape is formed by a photolithographic process and is used as a mask for eliminating the unnecessary portions of the aluminum layer by wet etching with HNO₃/H₃PO₄/ CH₃COOH aqueous solution, thereby forming the upper electrodes 9-1, 9-3 of the wiring matrixes and the gate electrode of the TFT.
(k) Finally a protective layer (not shown) is formed for example with organic resin. The photoelectric conversion device is thus completed.

The present invention allows to shorten the time of the entire manufacturing process, since the time-consuming semiconductor formation is present only in the step (c). Also the patterning of said semiconductor layer is conducted only once in the step (h). Thus, in comparison with the conventional process in which the semiconductor formation and patterning are respectively repeated twice, the gases and materials can be utilized more efficiently.

As explained in the foregoing, there can be obtained a photoelectric conversion device containing at least a photodiode, a switching element and wiring matrix on a same insulating substrate, which is less expensive due to a simpler manufacturing process, an improved yield and an improved utilization of the materials, since said photodiode, switching element and wiring matrix are of structures having a semiconductor layer of a same material and can be produced with a same manufacturing process.

## Claims

1. A thin film photoelectric conversion device comprising:
(i) a photodiode (10);
(ii) a switching element (11); and
(iii) a wiring section (12-2) provided on the same insulative substrate (1);
characterised in that:
a part of each of said photodiode, switching element and wiring section is formed from the same layer of hydrogenated amorphous silicon semiconductor material (4), said part being the active layer in the case of said photodiode and said switching element, and forming the support in the case of said wiring section.

2. A thin film photoelectric conversion device according to claim 1, wherein said semiconductor layer (3, 4, 5) is composed of a p-type hydrogenated amorphous silicon layer (3), an intrinsic hydrogenated amorphous silicon layer (4) and an n-type hydrogenated amorphous silicon layer (5).

3. A facsimile machine, an image reader or a digital scanner including a thin film photoelectric conversion device according to claim 1 or 2.

4. A method of producing a thin film photoelectric conversion device wherein:
(i) a photodiode (10) comprising a semiconductor layer (3) of first conductivity type, a semiconductor layer (5) of second conductivity type and a high resistivity semiconductor layer (4) therebetween, each of said semiconductor layers being hydrogenated amorphous silicon; and first (6-1) and second (2-1) electrode layers; and a protective layer (7-2);
(ii) a switching element consisting of a transistor (11) comprising a semiconductor layer (4) of hydrogenated amorphous silicon, source and drain electrode layers (6-2, 6-3), a gate insulating layer (7-3), and a gate electrode (9-2); and
(iii) a wiring section (12-2) comprising first and second wirings (6-4, 9-3), and an insulating layer (7-4) therebetween are provided on a common insulating substrate (1);
characterised in that:
said high resistivity semiconductor layer (4) of said photodiode and the semiconductor layer (4) of said transistor are simultaneously produced in a processing step;
one (6-1) of the first and second electrode layers, said source and drain electrode layers (6-2, 6-3), and one (6-4) of the first and second wirings are simultaneously produced in another processing step; and
said protective layer (7-2), said gate insulating layer (7-3) and said insulating layer (7-4) are simultaneously produced in yet another processing step.

## Patentansprüche

1. Photoelektrische Dünnfilm-Umwandlungsvorrichtung, umfassend:
(i) eine Photodiode (10);
(ii) ein Schaltelement (11); und
(iii) einen Verdrahtungsbereich (12-2),
die auf demselben isolierenden Substrat (1) vorgesehen sind;
dadurch gekennzeichnet, daß:
ein Teil von jeweils der Photodiode, dem Schaltelement und dem Verdrahtungsbereich aus derselben Schicht aus hydriertem amorphen Silizium-Halbleitermaterial (4) gebildet ist, wobei der Teil die aktive Schicht im Fall der Photodiode und des Schaltelements ist und im Fall des Verdrahtungsbereichs den Träger bildet.

2. Photoelektrische Dünnfilm-Umwandlungsvorrichtung nach Anspruch 1, wobei die Halbleiterschicht (3,4,5) aus einer hydrierten amorphen p-Typ-Siliziumschicht (3), einer hydrierten amorphen intrinsischen Siliziumschicht (4) und einer hydrierten amorphen n-Typ-Siliziumschicht (5) zusammengesetzt ist.

3. Faksimile-Gerät, Bildlesevorrichtung oder Digital-Scanner, umfassend eine photoelektrische Dünnfilm-Umwandlungsvorrichtung nach Anspruch 1 oder 2.

4. Verfahren zur Herstellung einer photoelektrischen Dünnfilm-Umwandlungsvorrichtung, wobei:
(i) eine Photodiode (10), umfassend eine Halbleiterschicht (3) von einem ersten Leitfähigkeitstyp, eine Halbleiterschicht (5) von einem zweiten Leitfähigkeitstyp und eine Halbleiterschicht (4) mit hoher Resistivität zwischen den beiden Schichten, wobei jede der Halbleiterschichten aus hydriertem amorphen Silizium ist; und erste (6-1) und zweite (2-1) Elektrodenschichten; und eine Schutzschicht (7-2) ;
(ii) ein Schaltelement bestehend aus einem Transistor (11), umfassend eine Halbleiterschicht (4) aus hydriertem amorphen Silizium, Source- und Drain-Elektrodenschichten (6-2, 6-3), eine Gate-Isolierschicht (7-3) und eine Gate-Elektrode (9-2); und
(iii) ein Verdrahtungsbereich (12-2); umfassend erste und zweite Verdrahtungen (6-4, 9-3) und eine isolierende Schicht (7-4) zwischen den Verdrahtungen
auf einem gemeinsamen isolierenden Substrat (1) vorgesehen sind;
daduch gekennzeichnet, daß:
die Halbleiterschicht (4) mit hoher Resistivität der Photodiode und die Halbleiterschicht (4) des Transistors gleichzeitig in einem Verarbeitungsschritt hergestellt werden;
eine (6-1) von der ersten und der zweiten Elektrodenschicht, die Source- und Drain-Elektrodenschichten (6-2, 6-3) und eine (6-4) von der ersten und der zweiten Verdrahtung in einem weiteren Verarbeitungsschritt gleichzeitig hergestellt werden; und
die Schutzschicht (7-2), die Gate-Isolierschicht (7-3) und die isolierende Schicht (7-4) gleichzeitig in noch einem weiteren Verarbeitungsschritt hergestellt werden.

## Revendications

1. Un dispositif de conversion photoélectrique à couches minces comprenant :
(i) une photodiode (10);
(ii) un élément de commutation (11); et
(iii) une section d'interconnexion (12-2) formés sur le même substrat isolant (1);
caractérisé en ce que :
une partie de chacun des éléments comprenant la photodiode, l'élément de commutation et la section d'interconnexion est formée à partir de la même couche de matériau semiconducteur en silicium amorphe hydrogéné (4), cette partie étant la couche active dans le cas de la photodiode et de l'élément de commutation, et formant le support dans le cas de la section d'interconnexion.

2. Un dispositif de conversion photoélectrique à couches minces selon la revendication 1, dans lequel la couche de semiconducteur (3, 4, 5) est constituée par une couche de silicium amorphe hydrogéné de type p (3), une couche de silicium amorphe hydrogéné intrinsèque (4) et une couche de silicium amorphe hydrogéné de type n (5).

3. Une machine de télécopie, un lecteur d'image ou un scanneur numérique comprenant un dispositif de conversion photoélectrique à couches minces selon la revendication 1 ou 2.

4. Un procédé de fabrication d'un dispositif de conversion photoélectrique à couches minces dans lequel :
(i) une photodiode (10) comprenant une couche de semiconducteur (3) d'un premier type de conductivité, une couche de semiconducteur (5) d'un second type de conductivité et une couche de semiconducteur à résistivité élevée (4) entre elles, chacune de ces couches de semiconducteur consistant en silicium amorphe hydrogéné; et des première (6-1) et seconde (2-1) couches d'électrodes; et une couche de protection (7-2);
(ii) un élément de commutation consistant en un transistor (11) qui comprend une couche de semiconducteur (4) en silicium amorphe hydrogéné, des couches d'électrodes de source et de drain (6-2, 6-3), une couche isolante de grille (7-3), et une électrode de grille (9-2); et
(iii) une section d'interconnexion (12-2) comprenant des première et seconde interconnexions (6-4, 9-3) et une couche isolante (7-4) entre elles
sont formés sur un substrat isolant commun (1);
caractérisé en ce que :
la couche de semiconducteur à résistivité élevée (4) de la photodiode et la couche de semiconducteur (4) du transistor sont produites simultanément au cours d'une étape de traitement;
l'une (6-1) des première et seconde couches d'électrodes, les couches d'électrodes de source et de drain (6-2, 6-3) et l'une (6-4) des première et seconde interconnexions sont produites simultanément au cours d'une autre étape de traitement; et
la couche de protection (7-2), la couche isolante de grille (7-3) et la couche isolante précitée (7-4) sont produites simultanément au cours d'encore une autre étape de traitement.
